# FASCICULE DE BREVET EUROPEEN

(11) **EP 3 948 949 B1**
(45) Date de publication et mention de la délivrance du brevet: **12.02.2025**
(21) Numéro de dépôt: 20713057.6
(22) Date de dépôt: 27.03.2020
(51) Int. Cl.: H01L 25/16, H01L 27/15, H01L 33/00, H01L 33/18, H01L 33/08, H01L 33/28, H01L 33/32, H01L 33/42, H01L 33/46, H01L 33/62

(54) **PROCÉDÉ DE FABRICATION D'UN ÉCRAN ÉMISSIF À LED TRIDIMENSIONNELLES ET ÉCRAN EN RÉSULTANT**
VERFAHREN ZUR HERSTELLUNG EINES EMISSIVEN DREIDIMENSIONALEN LED-BILDSCHIRMS UND RESULTIERENDER BILDSCHIRM
METHOD FOR MANUFACTURING A THREE-DIMENSIONAL LED-EMISSIVE DISPLAY AND RESULTING DISPLAY

(30) Priorité: 29.03.2019 FR 1903380
(43) Date de publication de la demande: 09.02.2022
(73) Titulaire: Commissariat à l'Energie Atomique et aux Energies Alternatives, 75015 Paris (FR)
(72) Inventeur: LEVY, François, 38054 Grenoble Cedex 9 (FR); AVENTURIER, Bernard, 38054 Grenoble Cedex 9 (FR); DESIERES, Yohan, 38054 Grenoble Cedex 9 (FR)
(74) Mandataire: Cabinet Beaumont
(86) Numéro de dépôt international: PCT/EP2020/058845
(87) Numéro de publication internationale: WO 2020/201150

(56) Documents cités:
- EP-A1- 2 357 676
- WO-A1-2011/048318
- WO-A1-2017/194845
- WO-A1-2019/002786
- US-A1- 2018 351 017

## Description

Le présent brevet revendique la priorité de la demande de brevet français FR19/03380.

### Domaine technique

La présente description concerne de façon générale les dispositifs optoélectroniques, et vise plus particulièrement la réalisation d'un écran d'affichage émissif à diodes électroluminescentes (LED) comportant des éléments semiconducteurs tridimensionnels, par exemple de type nanofils ou microfils.

### Technique antérieure

La demande de brevet WO 2011/048318 A1 décrit un procédé de fabrication d'un écran émissif à LED dans lequel chaque pixel de l'écran comprend plusieurs LED élémentaires comprenant chacune un nanofil semiconducteur, connectées en parallèle entre deux électrodes d'un circuit actif de contrôle de l'écran.

Une limitation de ce procédé est que les LED élémentaires des différents pixels de l'écran sont identiques ou similaire, de sorte que tous les pixels de l'écran émettent un rayonnement électromagnétique à une même longueur d'onde (i.e. tous les pixels de l'écran ont un pic d'émission à une même longueur d'onde). L'écran est dit monochromatique.

Pour réaliser un écran polychromatique, aussi appelé écran couleur, c'est-à-dire comportant des pixels de types différents adaptés à émettre des rayonnements électromagnétiques à des longueurs d'ondes distinctes (i.e. ayant des pics d'émission à des longueurs d'ondes distinctes), une possibilité est de prévoir, dans certains pixels de l'écran, des éléments de conversion de longueur d'onde adaptés à convertir le rayonnement électromagnétique émis par les LED du pixel en un rayonnement électromagnétique à une autre longueur d'onde. Ceci complexifie toutefois la fabrication de l'écran, notamment lorsque le pas inter-pixels de l'écran est faible, et peut de plus entrainer une diminution de son rendement de conversion électro-optique.

La demande de brevet WO 2019/002786 A1 décrit un exemple de procédé de fabrication d'un écran couleur dit à émission directe, c'est-à-dire dans lequel les pixels de types différents comportent des LED de natures différentes, chaque LED émettant directement à la longueur d'onde d'émission du pixel, sans passer par un élément de conversion de longueur d'onde. Chaque pixel de l'écran réalisé par ce procédé comprend plusieurs LED élémentaires constituées chacune d'un élément semiconducteur tridimensionnel, par exemple un nanofil ou un microfil semiconducteur, connectées en parallèle entre deux électrodes d'un circuit actif de contrôle de l'écran. Dans cet écran, les zones actives des LED élémentaires de pixels de types différents ont des compositions différentes, de façon à obtenir des longueurs d'ondes d'émission différentes.

Une limitation de ce procédé est qu'il comporte une étape de fixation d'une face d'un circuit actif de contrôle comportant une alternance de régions métalliques et de régions diélectriques, sur une face d'un circuit optoélectronique comportant un motif correspondant de régions métalliques et de régions diélectriques alternées. La fixation du circuit actif de contrôle au circuit optoélectronique peut être réalisée par collage direct hybride, c'est-à-dire par collage direct métal-métal des régions métalliques du circuit actif de contrôle sur les régions métalliques correspondantes du circuit optoélectronique, et par collage direct diélectrique-diélectrique des régions isolantes du circuit actif de contrôle sur les régions isolantes correspondantes du circuit optoélectronique. La mise en oeuvre d'un collage direct hybride nécessite toutefois une préparation des surfaces à assembler relativement délicate à mettre en oeuvre. En particulier, un tel collage implique de respecter certaines conditions sur le taux de couverture et la répartition métal/isolant des surfaces à assembler. Ceci complexifie la fabrication de l'écran dans la mesure où il faut alors prévoir, du côté de la face d'assemblage du circuit actif de contrôle et/ou du côté de la face d'assemblage du circuit optoélectronique, un niveau de métallisation supplémentaire, généralement en cuivre, visant à respecter ces conditions.

La demande de brevet WO 2017/194845 A1 décrit un procédé de fabrication d'un dispositif optoélectronique, avantageusement un dispositif d'affichage à LEDs de type mésas, comportant les étapes successives suivantes: a) rapporter, sur une face d'un circuit intégré de contrôle comportant une pluralité de plots métalliques de connexion, un empilement actif de diode comportant au moins des première et deuxième couches semiconductrices dopées de types de conductivité opposés, de façon que la deuxième couche de l'empilement soit électriquement connectée aux plots métalliques du circuit de contrôle; et b) former dans l'empilement actif des tranchées délimitant une pluralité de diodes connectées à des plots métalliques distincts du circuit de contrôle.

Il serait souhaitable de pouvoir disposer d'un procédé de fabrication d'un écran d'affichage couleur à LED à émission directe comportant des éléments semiconducteurs tridimensionnels, par exemple de type nanofils ou microfils, ce procédé palliant tout ou partie des inconvénients des procédés connus de fabrication d'un tel écran.

### Résumé de l'invention

Pour cela, la présente invention prévoit un procédé de fabrication d'un écran émissif à LED tridimensionnelles, selon la revendication 1 en annexe, comportant les étapes suivantes :
a) déposer une première couche métallique sur une face d'un circuit de contrôle comportant une pluralité de plots métalliques de connexion, la première couche métallique s'étendant sur toute la surface du circuit de contrôle et étant connectée électriquement aux plots métalliques de connexion du circuit de contrôle ;
b) déposer une deuxième couche métallique sur une face d'un circuit optoélectronique comportant des premières cellules d'émission adaptées à émettre un rayonnement électromagnétique à une première longueur d'onde et des deuxièmes cellules d'émission adaptées à émettre un rayonnement électromagnétique à une deuxième longueur d'onde différente de la première longueur d'onde, chaque première cellule d'émission comportant une ou plusieurs LED constituées chacune d'un élément semiconducteur tridimensionnel, la deuxième couche métallique s'étendant sur toute la surface du circuit optoélectronique et étant connectée électriquement à une première extrémité de chaque élément semiconducteur tridimensionnel du circuit optoélectronique ;
c) fixer le circuit optoélectronique au circuit de contrôle par collage direct de la deuxième couche métallique sur la première couche métallique, en alignant le circuit optoélectronique par rapport au circuit de contrôle de façon que les différentes cellules d'émission du circuit optoélectronique soient disposées en vis-à-vis de plots métalliques de connexion distincts du circuit de contrôle ; et
d) former, à partir de la face du circuit optoélectronique opposée au circuit de contrôle, des tranchées délimitant latéralement chaque cellule d'émission du circuit optoélectronique, les tranchées traversant les deuxième et première couches métalliques de façon que les différentes cellules élémentaires d'émission soient connectées à des plots métalliques de connexion distincts du circuit de contrôle, le procédé comprenant en outre la formation de murs d'isolation latéraux dans les tranchées, les murs d'isolation latéraux comprenant une couche isolante revêtant les parois latérales et le fond des tranchées, et une paroi centrale conductrice.

Selon un mode de réalisation de la présente invention, chaque deuxième cellule d'émission comporte une ou plusieurs LED constituées chacune d'un élément semiconducteur tridimensionnel.

Selon un mode de réalisation de la présente invention, la deuxième couche métallique comprend au moins une couche réfléchissante pour les rayonnements électromagnétiques émis par les premières et deuxième cellules d'émission.

Selon un mode de réalisation de la présente invention, la couche réfléchissante comprend de l'argent ou de l'aluminium.

Selon un mode de réalisation de la présente invention, la première couche métallique comprend une couche métallique de collage en contact avec une couche métallique de collage de la deuxième couche métallique, les couches métalliques de collage des première et deuxième couches métalliques étant en le même matériau.

Selon un mode de réalisation de la présente invention, les couches métalliques de collage des première et deuxième couches métalliques sont en Ti, Ni, Pt, Sn, Au, Ag, Al, Pd, W, Pb, Cu, AuSn, TiSn, NiSn ou en un alliage de tout ou partie de ces matériaux.

Selon un mode de réalisation de la présente invention, la paroi centrale conductrice est en un métal réfléchissant, par exemple de l'aluminium ou du tungstène.

Selon un mode de réalisation de la présente invention:
- les tranchées ont des parois latérales inclinées, et/ou ;
- un réflecteur constitué d'une alternance de couches diélectriques d'indices de réfraction distincts est formé sur les parois latérales des tranchées.

Selon un mode de réalisation de la présente invention, le procédé comporte en outre une étape de dépôt d'une couche conductrice transparente sur la face du circuit optoélectronique opposée au circuit de contrôle, la couche conductrice transparente étant en contact avec une deuxième extrémité de chaque élément semiconducteur tridimensionnel du circuit optoélectronique et formant une électrode commune à toutes les cellules d'émission du circuit optoélectronique.

Selon un mode de réalisation de la présente invention, la couche conductrice transparente est en graphène ou en un oxyde transparent et conducteur.

Selon un mode de réalisation de la présente invention, le procédé comporte en outre la formation d'une métallisation connectant électriquement la couche conductrice transparente à un ou plusieurs plots de connexion du circuit de contrôle.

Selon un mode de réalisation de la présente invention, la couche conductrice transparente est en contact, par sa face inférieure, avec la face supérieure des parois centrales conductrices des murs d'isolation latéraux.

Selon un mode de réalisation de la présente invention, le circuit optoélectronique comporte en outre des troisièmes cellules d'émission adaptées à émettre un rayonnement électromagnétique à une troisième longueur d'onde différente des première et deuxième longueurs d'ondes.

La présente invention prévoit également un écran émissif à LED tridimensionnelles, selon la revendication 14 en annexe, comportant :
- un circuit de contrôle dont une face comporte une pluralité de plots métalliques de connexion, une première couche métallique s'étendant sur ladite face du circuit de contrôle et étant connectée électriquement aux plots métalliques de connexion du circuit de contrôle ; et
- un circuit optoélectronique comportant des premières cellules d'émission adaptées à émettre un rayonnement électromagnétique à une première longueur d'onde et des deuxièmes cellules d'émission adaptées à émettre un rayonnement électromagnétique à une deuxième longueur d'onde différente de la première longueur d'onde, chaque première cellule d'émission comportant une ou plusieurs LED constituées chacune d'un élément semiconducteur tridimensionnel, une deuxième couche métallique s'étendant sur une face du circuit optoélectronique et étant connectée électriquement à une première extrémité de chaque élément semiconducteur tridimensionnel du circuit optoélectronique, dans lequel le circuit optoélectronique est fixé au circuit de contrôle par collage direct de la deuxième couche métallique sur la première couche métallique, de façon que les différentes cellules d'émission du circuit optoélectronique soient disposées en vis-à-vis de plots métalliques de connexion distincts du circuit de contrôle, et dans lequel l'écran comprend une pluralité de tranchées formées à partir de la face du circuit optoélectronique opposée au circuit de contrôle, les tranchées délimitant latéralement chaque cellule d'émission du circuit optoélectronique, les tranchées traversant les deuxième et première couches métalliques de façon que les différentes cellules élémentaires d'émission soient connectées à des plots métalliques de connexion distincts du circuit de contrôle, dans lequel les tranchées contiennent des murs d'isolation latéraux comprenant une couche isolante revêtant les parois latérales et le fond des tranchées, et une paroi centrale conductrice.

### Brève description des dessins

Ces caractéristiques et avantages, ainsi que d'autres, seront exposés en détail dans la description suivante de modes de réalisation particuliers, certains modes étant suivant la présente invention telle que revendiquée tandis que d'autres ne le sont pas mais leur exposé étant nécessaire pour comprendre la présente invention, faite à titre non limitatif en relation avec les figures jointes parmi lesquelles :
la figure 1 illustre une étape d'un premier procédé de fabrication d'un écran d'affichage émissif à LED selon un mode de réalisation illustratif du contexte de la présente invention telle que revendiquée mais ne la définissant pas strictement en soi;
la figure 2 illustre une autre étape du premier procédé ;
la figure 3 illustre une autre étape du premier procédé ;
la figure 4 illustre une autre étape du premier procédé ;
la figure 5 illustre une autre étape du premier procédé ;
la figure 6 illustre une autre étape du premier procédé ;
la figure 7 illustre une autre étape du premier procédé ;
la figure 8 illustre une autre étape du premier procédé ;
la figure 9 illustre une autre étape du premier procédé ;
la figure 10 illustre une autre étape du premier procédé ;
la figure 11 illustre une autre étape du premier procédé ;
la figure 12 illustre une autre étape du premier procédé ;
la figure 13 illustre une autre étape du premier procédé ;
la figure 14 illustre une autre étape du premier procédé ;
la figure 15 illustre une autre étape du premier procédé ;
la figure 16 illustre une autre étape du premier procédé ;
la figure 17 illustre une étape d'un deuxième procédé de fabrication d'un écran d'affichage émissif à LED selon un mode de réalisation de la présente invention telle que revendiquée;
la figure 18 illustre une autre étape du deuxième procédé ; et
la figure 19 illustre une autre étape du deuxième procédé.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des circuits de commande des LED des écrans d'affichage décrits n'a pas été détaillée, les modes de réalisation décrits étant compatibles avec les réalisations usuelles de tels circuits de commande. De plus, les différentes étapes de croissance épitaxiales mises en oeuvre pour réaliser les LED élémentaires tridimensionnelles des écrans d'affichage décrits n'ont pas été détaillées, les modes de réalisation décrits étant compatibles avec les procédés connus de réalisation de telles LED élémentaires tridimensionnelles, par exemple les procédés décrits dans la demande de brevet WO 2019/002786 A1 susmentionnée.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les structures décrites peuvent être orientées différemment.

Sauf précision contraire, les expressions "environ", "approximativement", "sensiblement", et "de l'ordre de" signifient à 10 % près, de préférence à 5 % près.

La présente invention concerne notamment des écrans d'affichage à LED comportant des LED élémentaires constituées chacune d'un élément semiconducteur tridimensionnel, par exemple de type nanofil ou microfil. On entend ici par élément semiconducteur tridimensionnel un élément de forme allongée selon une direction privilégiée appelée direction longitudinale. Un tel élément peut avoir une forme filaire, ou encore une forme conique ou tronconique, ou une forme pyramidale. A titre d'exemple, chaque élément semiconducteur tridimensionnel a une dimension transversale maximale comprise entre 5 nm et 2,5 µm, par exemple entre 50 nm et 1 µm, et une dimension longitudinale supérieure ou égale à 1 fois, de préférence supérieure ou égale à 5 fois, sa dimension transversale maximale.

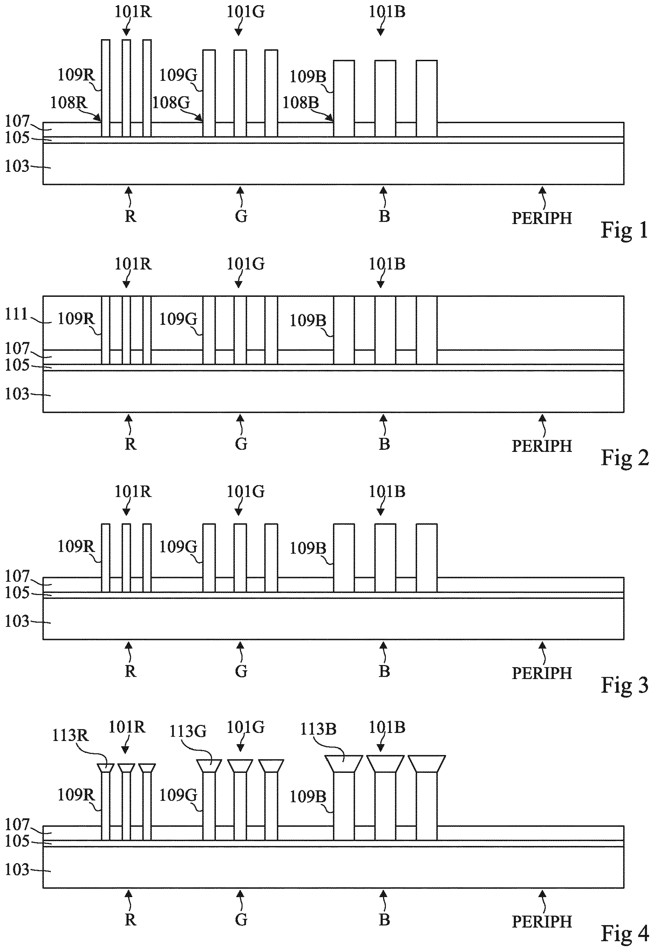

Les figures 1 à 16 sont des vues en coupe schématiques et partielles des structures obtenues à des étapes d'un exemple d'un procédé de fabrication d'un écran d'affichage émissif à LED selon un mode de réalisation illustratif du contexte de la présente invention telle que revendiquée mais ne la définissant pas strictement, en soi. On considère ici plus particulièrement la réalisation d'un écran d'affichage couleur à émission directe (sans éléments de conversion de longueur d'onde), comportant des éléments semiconducteurs tridimensionnels. Dans cet exemple, l'écran d'affichage comporte trois types de pixels différents, désignés respectivement sur les figures par les références R, G et B, adaptés à émettre respectivement des rayonnements électromagnétiques à trois longueurs d'ondes distinctes, par exemple adaptés à émettre respectivement de la lumière rouge, de la lumière verte, et de la lumière bleue. Les modes de réalisation décrits peuvent toutefois s'appliquer quel que soit le nombre de types de pixels différents de l'écran, supérieur ou égal à deux. Sur les figures, seul un pixel rouge R, un pixel vert G et un pixel bleu B ont été représenté. En pratique, l'écran peut comporter un grand nombre de pixels de chaque type, étant entendu que les pixels d'un même type sont sensiblement identiques (aux dispersions de fabrication près). Le pas inter-pixels est par exemple inférieur à 15 µm, de préférence inférieur ou égal à 5 µm. On a en outre représenté sur les figures 1 à 16 une portion d'une partie périphérique PERIPH de l'écran, entourant, en vue de dessus (non représentée), l'ensemble des pixels R, G et B de l'écran.

Les figures 1 à 7 illustrent plus particulièrement des étapes successives de fabrication d'un circuit optoélectronique comportant, pour chaque pixel R, G et B de l'écran, une cellule d'émission 101R, respectivement 101G, respectivement 101B, commandable individuellement pour émettre un rayonnement électromagnétique à la longueur d'onde d'émission du pixel. Chaque cellule d'émission comporte une ou plusieurs LED élémentaires connectées en parallèle, constituées chacune d'un élément semiconducteur tridimensionnel de type nanofil ou microfil. Chaque LED élémentaire est adaptée à émettre un rayonnement électromagnétique à la longueur d'onde d'émission du pixel à laquelle elle appartient. Les axes longitudinaux de l'ensemble des éléments semiconducteurs tridimensionnels de l'écran sont sensiblement parallèles. Dans chaque cellule d'émission, les LED élémentaires de la cellule ont sensiblement les mêmes dimensions et sont régulièrement réparties sur la surface de la cellule. Les LED élémentaires de pixels de types différents ont en revanche des dimensions transversales différentes et/ou les cellules d'émission de pixels de types différents présentent des espacements ou pas inter-LED différents.

La figure 1 représente une structure obtenue après les étapes successives suivantes :
- déposer, sur la face supérieure d'un substrat de support 103, une couche de nucléation 105 aussi appelée couche de germination ;
- déposer sur la face supérieure de la couche de nucléation 105 une couche isolante électriquement 107 ;
- former dans la couche isolante 107 des ouvertures traversantes 108R, 108G et 108B de façon à exposer des parties de la couche de nucléation 105 aux emplacements souhaités des LED élémentaires de l'écran ;
- faire croître simultanément des fils semiconducteurs 109R, 109G et 109B depuis la couche de nucléation 105 en vis-à-vis des ouvertures 108R, respectivement 108G, respectivement 108B.

Le substrat 103 peut être une structure monobloc, ou peut correspondre à une couche recouvrant un support constitué d'un autre matériau. Le substrat 103 est par exemple en un matériau semiconducteur, par exemple en silicium. A titre d'exemple, le substrat 103 est en silicium monocristallin, la face supérieure du substrat 103 étant par exemple d'orientation cristalline <111>. Le substrat 103 peut correspondre à une structure multicouches de type silicium sur isolant, également appelée SOI (de l'anglais Silicon On Insulator). A titre de variante, le substrat 103 est un substrat en germanium, en carbure de silicium, en un composé III-V, tel que du GaN ou du GaAs, ou un substrat en ZnO, ou un substrat conducteur, par exemple un substrat en un métal ou un alliage métallique, notamment le cuivre, le titane, le molybdène, un alliage à base de nickel et l'acier.

La couche de nucléation 105 comprend un ou plusieurs matériaux qui favorisent la croissance des éléments semiconducteurs tridimensionnels constitutifs des LED élémentaires du circuit optoélectronique. A titre d'exemple, la couche 105 comprend un empilement (non détaillé sur la figure) d'au moins deux couches de matériaux distincts, chacune des couches de l'empilement pouvant être un métal, un oxyde métallique, un nitrure, un carbure ou un borure d'un métal de transition de la colonne IV, V ou VI du tableau périodique des éléments ou une combinaison de ces composés et de préférence un nitrure d'un métal de transition de la colonne IV, V ou VI du tableau périodique des éléments ou une combinaison de ces composés. A titre d'exemple, chacune des couches de l'empilement 105 peut être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. Chacune des couches de l'empilement 105 a, par exemple, une épaisseur comprise entre 1 nm et 100 nm, de préférence comprise entre 10 nm et 30 nm.

La couche isolante 107 peut être une couche unique, ou comprendre un empilement de plusieurs couches isolantes successives en des matériaux distincts. A titre d'exemple, la couche 107 comprend un empilement de deux couches isolantes (non détaillées sur les figures) en des matériaux distincts, chacune des deux couches de l'empilement étant en un matériau choisi dans le groupe comprenant l'oxyde de silicium (SiO₂), le nitrure de silicium (SiₓN_{y}, où x est environ égal à 3 et y est environ égal à 4, par exemple du Si₃N₄), l'oxynitrure de silicium (notamment de formule générale SiOₓN_{y}, par exemple du Si₂ON₂), l'oxyde d'hafnium (HfO₂) ou l'oxyde d'aluminium (Al₂O₃). A titre d'exemple, la première couche ou couche inférieure de l'empilement 107 est en oxyde de silicium et la deuxième couche ou couche supérieure de l'empilement 107 est en nitrure de silicium. L'épaisseur de chaque couche isolante de l'empilement 107 est par exemple comprise entre 10 nm et 100 nm, de préférence entre 20 nm et 60 nm, par exemple égale à environ 40 nm.

Dans cet exemple, les ouvertures 108R, respectivement 108G, respectivement 108B sont formées aux emplacements souhaités des LED élémentaires des cellules d'émission 101R, respectivement 101G, respectivement 101B. Les dimensions latérales des ouvertures 108R, respectivement 108G, respectivement 108B correspondent sensiblement aux dimensions transversales souhaitées des éléments semiconducteurs tridimensionnels constitutifs des LED élémentaires des pixels R, respectivement G, respectivement B de l'écran. Ainsi, dans chaque cellule d'émission 101R, respectivement 101G, respectivement 101B, les ouvertures 108R, respectivement 108G, respectivement 108B de la cellule ont sensiblement les mêmes dimensions et sont régulièrement réparties sur la surface de la cellule. Les ouvertures 108R, 108G, 108B de pixels de types différents ont en revanche des dimensions latérales différentes et/ou les cellules d'émission de pixels de types différents présentent des espacements ou pas inter-ouvertures différents.

Chaque fil semiconducteur 109R, 109G, 109B est par exemple en un matériau semiconducteur choisi dans le groupe comprenant les composés III-V, les composés II-VI ou les semiconducteurs ou composés du groupe IV. Chaque fil semiconducteur 109R, 109G, 109B peut être au moins en partie, formé à partir d'un premier matériau semiconducteur comportant majoritairement un composé III-V, par exemple un composé III-N, un composé II-VI ou au moins un élément du groupe IV. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires. Des exemples de matériaux semiconducteurs du groupe IV sont le silicium (Si), le carbone (C), le germanium (Ge), les alliages de carbure de silicium (SiC), les alliages silicium-germanium (SiGe) ou les alliages de carbure de germanium (GeC). Le matériau semiconducteur des fils 109R, 109G et 109B peut comporter un dopant, par exemple du silicium assurant un dopage de type N d'un composé III-N, ou du magnésium assurant un dopage de type P d'un composé III-N.

Chaque fil 109R, 109G, 109B peut avoir une forme allongée selon un axe sensiblement perpendiculaire à la face supérieure du substrat 103, par exemple une forme générale cylindrique. Chaque fil 109R, 109G, 109B peut avoir un diamètre, en section transversale, compris entre 5 nm et 2,5 µm, par exemple entre 50 nm et 1 µm. Les axes longitudinaux de deux fils 109R, 109G, 109B adjacents peuvent être distants de 100 nm à 3 µm et de préférence de 200 nm à 1,5 µm.

La hauteur (dimension longitudinale) de chaque fil 109R, 109G, 109B à la fin de l'étape de croissance peut être comprise entre 250 nm et 15 µm, de préférence entre 500 nm et 5 µm, plus préférentiellement entre 1 µm et 3 µm. Dans cet exemple, à la fin de l'étape de croissance, les fils 109R, 109G et 109B ont des hauteurs différentes. La hauteur de chaque fil 109R, 109G et 109B dépend notamment du diamètre du fil et de l'écart entre les fils (qui dépendent eux-mêmes des dimensions latérales des ouvertures 108R, 108G et 108B et de l'écart entre les ouvertures).

A titre d'exemple, le procédé de formation des fils 109R, 109G et 109B peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphoshine (TBT), l'arsine (AsH₃) ou le diméthylhydrazine (UDMH).

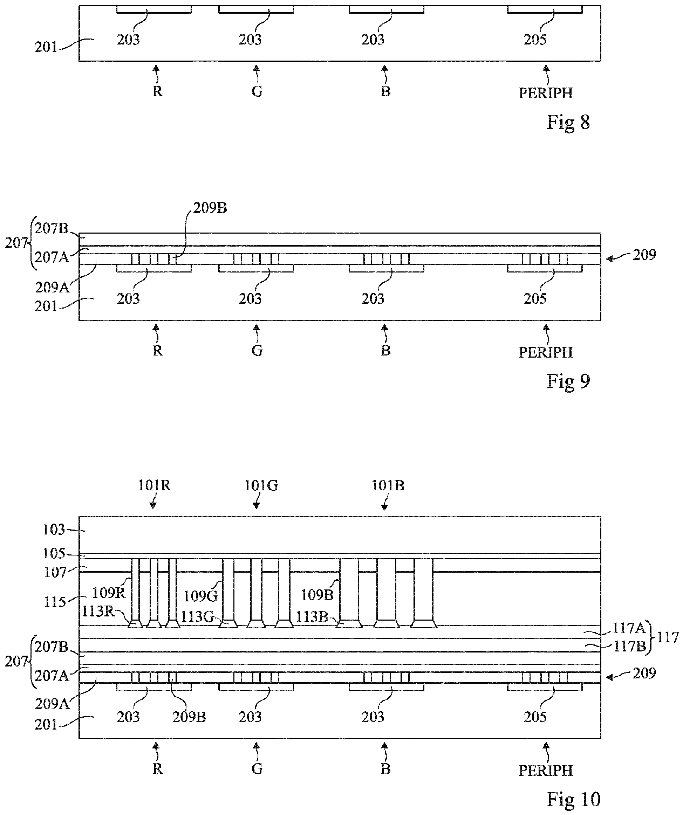

La réalisation de la structure de la figure 1 est par exemple identique ou similaire à celle de la structure de la figure 8A de la demande de brevet WO 2019/002786 A1 susmentionnée.

La figure 2 représente la structure obtenue après les étapes successives supplémentaires suivantes :
- déposer une couche diélectrique ou polymère 111 sur la totalité de la face supérieure de la structure de la figure 1, c'est-à-dire sur les fils semiconducteurs 109R, 109G et 109B et sur la face supérieure de la couche isolante 107 ; et
- amincir et planariser la couche diélectrique 111 et une partie supérieure des fils 109R, 109G et 109B de façon à définir une face supérieure plane, de préférence parallèle à la face supérieure du substrat 103.

La couche 111 peut être en un matériau différent du matériau formant la partie supérieure de la couche 107. La hauteur minimale de la couche 111 avant amincissement et planarisation est par exemple supérieure à la hauteur des plus petits des fils 109R, 109G, 109B. De préférence, la hauteur minimale de la couche 111 avant amincissement et planarisation est supérieure à la hauteur des plus grands des fils 109R, 109B et 109G, par exemple au moins égale à une fois et demi la hauteur des plus grands des fils 109R, 109B et 109G.

L'amincissement et la planarisation de la couche 111 et des fils 109R, 109G, 109B sont par exemple réalisés par planarisation mécano-chimique ou CMP (de l'anglais Chemical-Mechanical planarization). Après cette étape, tous les fils 109R, 109G et 109B ont sensiblement la même hauteur, correspondant à la somme des épaisseurs des couches isolantes 107 et 111, par exemple comprise entre 150 nm et 10 µm.

La figure 3 représente la structure obtenue après avoir retiré entièrement la couche 111 pour exposer la couche isolante 107 et une partie supérieure des flancs des fils 109R, 109G, 109B. La couche isolante 107 peut jouer le rôle de couche d'arrêt lors de la gravure de la couche 111. Le retrait de la couche 111 peut être réalisé par une gravure humide. Dans le cas où la couche 111 est en un matériau polymère, son retrait peut être effectué par pelage ou "stripping", ou encore par gravure sèche. A titre de variante, la gravure de la couche 111 peut être seulement partielle, une couche résiduelle étant conservée sur la couche isolante 107.

A titre de variante, les étapes des figures 2 et 3 peuvent être omises si les fils 109R, 109G et 109B ont déjà sensiblement la même hauteur à l'issue des étapes de la figure 1.

La figure 4 représente la structure obtenue à l'issue d'une étape de formation simultanée, par croissance épitaxiale, de têtes 113R, respectivement 113G, respectivement 113B, sur et en contact avec la face supérieure des fils 109R, respectivement 109G, respectivement 109B. Chaque tête 113R, 113G, 113B peut comporter un empilement vertical (non détaillé sur les figures) comportant, dans l'ordre à partir de la face supérieure du fil 109R, 109G ou 109B correspondant, une portion semiconductrice inférieure du même matériau que le fil et dopée d'un premier type de conductivité, par exemple de type N, une zone active, et une portion semiconductrice supérieure dopée du second type de conductivité, par exemple de type P. Une couche de passivation, non représentée, peut être présente sur les flancs latéraux de la tête.

L'ensemble formé par chaque fil 109R, 109G, 109B, et la tête 113R, 113G, 113B associée constitue une LED élémentaire filaire en configuration axiale. La tête 113R, 113G, 113B comprend notamment une zone active qui est la couche depuis laquelle est émise la majorité du rayonnement électromagnétique fourni par la LED. A titre d'exemple, la zone active peut comporter des moyens de confinement tels que des puits quantiques multiples. La LED est dite en configuration axiale dans la mesure où la jonction PN définie entre la portion semiconductrice inférieure et la portion semiconductrice supérieure de la tête 113R, 113G, 113B est une jonction planaire sensiblement orthogonale à l'axe longitudinal central du fil semiconducteur 109R, 109G, 109B.

Dans l'exemple représenté sur la figure 4, la section droite de chaque tête 113R, 113G, 113B augmente au fur et à mesure que l'on s'éloigne du fil 109R, 109G, 109B, et les portions semiconductrices supérieures des têtes 113R, 113G, 113B de LED adjacentes sont disjointes. A titre de variante, les portions semiconductrices supérieures des têtes 113R, 113G, 113B de LED adjacentes peuvent coalescer. Plus généralement, les têtes 113R, 113G, 113B des LED peuvent avoir d'autres formes que celles représentées en figure 4, par exemple les formes décrites en relation avec les figures 2, 3, 4, 5, 6 et 7 de la demande de brevet WO 2019/002786 A1 susmentionnée.

Les couches successives formant les têtes 113R, 113G, 113B peuvent être réalisées par un procédé similaire à celui utilisé pour la formation des fils 109R, 109G, 109B. La formation des zones actives des têtes 113R, 113G, 113B peut comprendre, en plus de l'injection dans le réacteur d'un précurseur d'un élément du groupe III et d'un précurseur d'un élément du groupe V, un précurseur d'un élément supplémentaire, par exemple de l'indium. Le taux d'incorporation de l'élément supplémentaire dans la zone active dépend notamment des dimensions latérales des zones actives, et de l'écart entre les fils. On obtient ainsi des taux d'incorporation d'indium différents pour les zones actives des têtes 113R, 113G et 113B, bien qu'elles soient formées simultanément. En fonctionnement, les têtes 113R, 113G et 113B sont alors adaptées à émettre des rayonnements électromagnétiques à des longueurs d'onde différentes.

Les têtes 113R, 113G et 113B sont par exemple réalisées de façon identique ou similaire à ce qui a été décrit dans la demande de brevet WO 2019/002786 A1 susmentionnée.

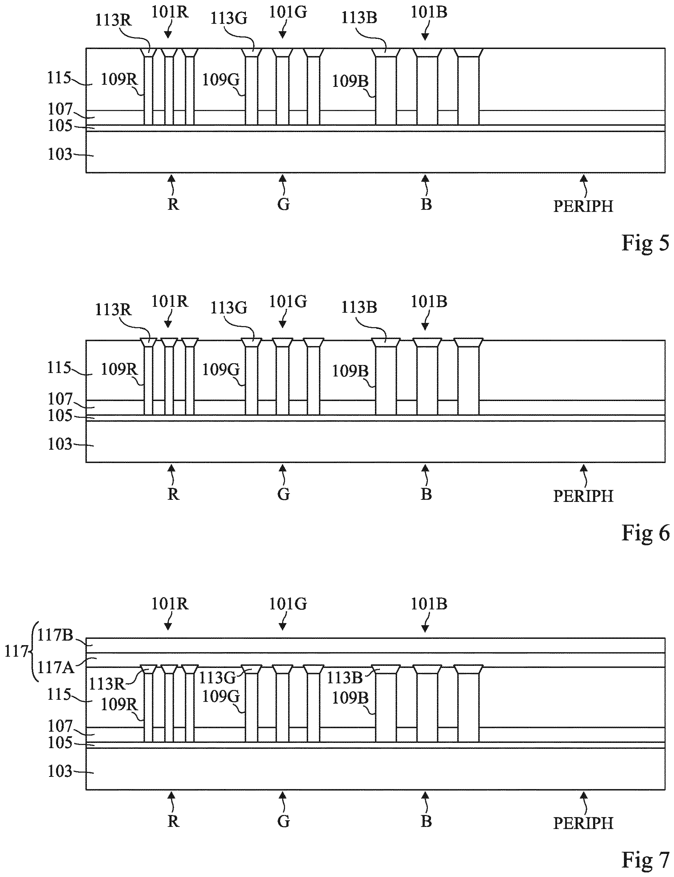

La figure 5 représente la structure obtenue après les étapes successives supplémentaires suivantes :
- déposer une couche diélectrique ou polymère 115 sur la totalité de la face supérieure de la structure de la figure 4, c'est-à-dire sur les LED élémentaires formées par les fils 109R, 109G, 109B et les têtes 113R, 113G, 113B, ainsi que sur la face supérieure de la couche isolante 107 ; et
- amincir et planariser la couche diélectrique 115 et une partie supérieure des têtes 113R, 113G et 113B de façon à définir une face supérieure plane, de préférence parallèle à la face supérieure du substrat 103.

La hauteur minimale de la couche 115 avant amincissement et planarisation est par exemple supérieure à la hauteur des plus petites des têtes 113R, 113G, 113B. De préférence, la hauteur minimale de la couche 115 avant amincissement et planarisation est supérieure à la hauteur des plus hautes des têtes 113R, 113G, 113B. L'amincissement et la planarisation de la couche 115 et des têtes 113R, 113G, 113B sont par exemple réalisés par CMP. A l'issue de cette étape, les faces supérieures des portions semiconductrices supérieures des têtes 113R, 113G, 113B affleurent au niveau de la face supérieure de la couche diélectrique 115.

A titre de variante, la planarisation peut s'arrêter au-dessus de la face supérieure des têtes 113R, 113G et 113B, la libération de la face supérieure des têtes étant alors réalisée lors de l'étape supplémentaire de gravure de la figure 6.

La figure 6 représente la structure obtenue à l'issue d'une étape supplémentaire de gravure d'une partie supérieure de la couche diélectrique 115. Lors de cette étape, les têtes 113R, 113G et 113B ne sont pas gravées. Cette gravure, optionnelle, vise à bien nettoyer les faces supérieures des têtes 113R, 113G et 113B et à dégager les flancs d'une partie de la portion semiconductrice supérieure de chaque tête, en vue de la reprise d'un contact électrique sur les têtes 113R, 113G, 113B. La gravure est de préférence interrompue avant d'atteindre les flancs des zones actives des têtes 113R, 113G, 113B. La gravure mise en oeuvre lors de cette étape est par exemple une gravure du type gravure ionique réactive (RIE, de l'anglais Reactive-Ion Etching) ou une gravure à plasma à couplage inductif (ICP, de l'anglais Inductively Coupled Plasma) .

La figure 7 représente la structure obtenue à l'issue d'une étape supplémentaire de dépôt d'une couche métallique 117 de reprise d'un contact électrique sur la face supérieure des têtes 113R, 113G, 113B du circuit. La couche 117 s'étend de façon continue sur sensiblement toute la surface supérieure du circuit optoélectronique. Ainsi, à ce stade, toutes les LED du circuit optoélectronique ont leurs portions semiconductrices supérieures connectées les unes aux autres par la couche métallique 117.

Les figures 8 et 9 illustrent des étapes successives de fabrication d'un circuit actif de contrôle de l'écran d'affichage.

La figure 8 représente de façon schématique un circuit intégré de contrôle formé dans et sur un substrat semiconducteur 201, par exemple un substrat en silicium. Dans cet exemple, le circuit de contrôle comprend, du côté de sa face supérieure, pour chaque pixel R, G, B de l'écran, un plot métallique de connexion 203 destiné à être connecté aux électrodes supérieures (dans l'orientation de la figure 7) de chacune des LED élémentaires de la cellule d'émission 101R, 101G, 101B du pixel, de façon à pouvoir commander un courant circulant dans l'ensemble de LED élémentaires de la cellule et/ou appliquer une tension aux bornes de l'ensemble de LED de la cellule. Le circuit de contrôle comprend par exemple, pour chaque pixel, connectée au plot métallique 203 du pixel, une cellule élémentaire de contrôle (non détaillée sur les figures) comportant un ou plusieurs transistors, permettant de contrôler le courant circulant dans l'ensemble de LED élémentaires du pixel et/ou la tension appliquée aux bornes de l'ensemble de LED élémentaires du pixel. Le contact sur les électrodes inférieures (dans l'orientation de la figure 7) des LED élémentaires peut être pris de façon collective, par exemple dans la région périphérique PERIPH du circuit de contrôle, par l'intermédiaire d'un ou plusieurs plots métalliques de connexion 205 identiques ou similaires aux plots métalliques 203. Le circuit de contrôle est par exemple réalisé en technologie CMOS. Les plots métalliques 203 et 205, par exemple en cuivre ou en aluminium, peuvent être latéralement entourés par un matériau isolant, par exemple de l'oxyde de silicium, de façon que le circuit de contrôle présente une surface supérieure sensiblement plane comprenant une alternance de régions métalliques 203, 205 et de régions isolantes.

A titre de variante, les plots métalliques 203 et 205 peuvent être revêtus par une couche isolante de passivation, non visible sur la figure 8 auquel cas ils n'affleurent pas du côté de la face supérieure du circuit.

La figure 9 illustre la structure obtenue après une étape de dépôt d'une couche métallique 207 sur la face supérieure du circuit de contrôle de la figure 8. La couche métallique 207 s'étend de façon continue sur sensiblement toute la surface du circuit de contrôle. Dans cet exemple, la couche métallique 207 est électriquement en contact avec l'ensemble des plots métalliques de connexion 203 et 205 du circuit de contrôle. Dans l'exemple de la figure 9, une structure d'interconnexion 209 fait interface entre la face supérieure de la structure de la figure 8 et la couche métallique 207. La structure d'interconnexion 209 comprend une couche diélectrique 209A déposée de façon continue sur sensiblement toute la surface de la structure de la figure 8, et, pour chaque plot de connexion métallique 203, 205 du circuit de contrôle, un ou plusieurs vias conducteurs 209B, par exemple en métal, traversant la couche diélectrique 209A et reliant la face supérieure du plot métallique 203, 205 à la face inférieure de la couche métallique 207. La couche diélectrique 209A peut être soit une couche de passivation déjà présente à la surface du circuit et encapsulant les plots métalliques 203 à 205, soit une couche reportée en surface du circuit dans le cas où les plots 203 et 205 affleurent au niveau de la face supérieure du circuit. A titre de variante, la structure d'interconnexion 209 peut être omise, la couche métallique 207 étant alors déposée directement sur et en contact avec la face supérieure du circuit de la figure 8.

Les figures 10 à 16 illustrent des étapes successives de réalisation de l'écran d'affichage à partir du circuit optoélectronique de la figure 7 et du circuit de contrôle de la figure 9.

La figure 10 illustre la structure obtenue après une étape de report du circuit optoélectronique de la figure 7 sur le circuit de contrôle de la figure 9, la couche métallique 117 du circuit optoélectronique étant tournée vers la couche métallique 207 du circuit de contrôle. Sur les figures 10 à 16, l'orientation du circuit optoélectronique est inversée par rapport à la figure 7, tandis que l'orientation du circuit actif de contrôle est identique à celle de la figure 9.

Lors du report, le circuit optoélectronique est aligné par rapport au circuit actif de contrôle de façon que les différentes cellules d'émission 101R, 101G, 101B du circuit optoélectronique soient disposées en vis-à-vis de plots métalliques de connexion 203 distincts du circuit actif de contrôle. Pour cela, le circuit optoélectronique peut être aligné sur des repères (non représentés) préalablement formés sur le circuit de contrôle, et/ou le circuit de contrôle peut être aligné sur des repères (non représentés) préalablement formés sur le circuit optoélectronique. Préalablement à l'étape de report, les repères d'alignement peuvent être dégagés, par exemple par un retrait localisé de la couche métallique 207 et/ou de la couche métallique 117 en vis-à-vis des repères. Dans l'exemple représenté, chaque cellule d'émission 101R, 101G, 101B est située, en projection verticale, en regard d'un unique plot métallique 203 du circuit de contrôle.

Le circuit optoélectronique est ensuite fixé au circuit de contrôle par collage direct métal-métal de la face inférieure (dans l'orientation des figures 10 à 16) de la couche métallique 117 du circuit optoélectronique sur la face supérieure de la couche métallique 207 du circuit de contrôle. Par collage direct, on entend ici une fixation sans ajout de matière entre les deux surfaces à assembler, par exemple un collage moléculaire et/ou un collage par thermocompression.

Un avantage lié à l'utilisation d'un collage direct métal-métal (ou collage homogène métal-métal) pour assembler le circuit optoélectronique et le circuit actif de contrôle est qu'un tel collage est plus simple à mettre en oeuvre et nécessite moins d'étapes de préparation qu'un collage direct hybride métal-métal/diélectrique-diélectrique. Ceci peut en outre permettre la réalisation d'un écran entièrement dépourvu de cuivre.

Pour assurer un bon collage, la couche métallique 117 présente de préférence une partie inférieure en le même métal qu'une partie supérieure de la couche métallique 207. De plus, la couche métallique 117 est de préférence choisie pour réaliser un bon contact ohmique avec les portions semiconductrices inférieures (dans l'orientation des figures 10 à 16) des LED élémentaires des pixels. La couche métallique 117 est en outre de préférence réfléchissante pour les rayonnements électromagnétiques émis par les LED élémentaires des pixels, de façon à augmenter l'efficacité d'émission et éviter des déperditions de lumière dans le circuit de contrôle. L'écran réalisé est en effet destiné à émettre de la lumière par sa face supérieure (dans l'orientation de la figure 10), c'est-à-dire par sa face opposée au circuit de contrôle. Par ailleurs, la couche 207 et/ou la couche 117 peuvent être choisies de façon à éviter que du métal des plots de connexion 203, 205 du circuit de contrôle, par exemple du cuivre, ne diffuse vers les portions semiconductrices inférieures des LED élémentaires du circuit optoélectronique, ce qui pourrait notamment dégrader la qualité du contact ohmique entre la couche 117 et les LED élémentaires.

En pratique, chacune des couches 207 et 117 peut être une couche unique ou un empilement d'une ou plusieurs couches de métaux différents permettant d'assurer tout ou partie des fonctions susmentionnées.

A titre d'exemple la couche 207 comprend une couche supérieure en un métal de même nature qu'une couche inférieure de la couche 117, ce métal étant choisi pour obtenir un bon collage entre les deux structures, par exemple un métal du groupe comprenant le titane, le nickel, le platine, l'étain, l'or, l'argent, l'aluminium, le palladium, le tungstène, le plomb, le cuivre, un alliage or-étain, un alliage titane-étain, un alliage nickel-étain, ou un alliage de tout ou partie de ces matériaux. L'empilement formé par les couches 207 et 117 peut en outre comprendre une ou plusieurs couches en des métaux adaptés à réfléchir la lumière émise par les LED, par exemple de l'argent ou de l'aluminium. De plus, l'empilement formé par les couches 207 et 117 peut comprendre une ou plusieurs couches adaptées à faire barrière à la diffusion de métaux tels que le cuivre ou l'argent compris dans l'empilement 207/117 et/ou dans les plots métalliques 203, 205, par exemple une ou plusieurs couches du groupe comprenant le nitrure de tantale, le nitrure de titane, le nitrure de tungstène, un alliage titane-tungstène, ou une combinaison de tout ou partie de ces matériaux.

Dans l'exemple représenté, la couche 117 comprend une couche inférieure supérieure 117A en un métal réfléchissant pour les rayonnement électromagnétiques émis par les LED et permettant d'assurer un bon contact ohmique avec les portions semiconductrices inférieures des LED, par exemple de l'aluminium ou de l'argent (avec éventuellement une fine couche d'interface, par exemple en platine, nickel ou palladium permettant d'assurer un bon contact ohmique dans le cas du nitrure de gallium de type P), et une couche supérieure 117B en un métal adapté à assurer un collage de bonne qualité avec la couche 207, par exemple du titane. De plus, dans cet exemple, la couche 207 comprend une couche inférieure 207A en un métal adapté à réaliser une bonne connexion électrique avec les plots métalliques 203, 205 (par l'intermédiaire des vias 209B le cas échéant), par exemple du tungstène ou du cuivre, et une couche supérieure 207B en le même métal que la couche 117B.

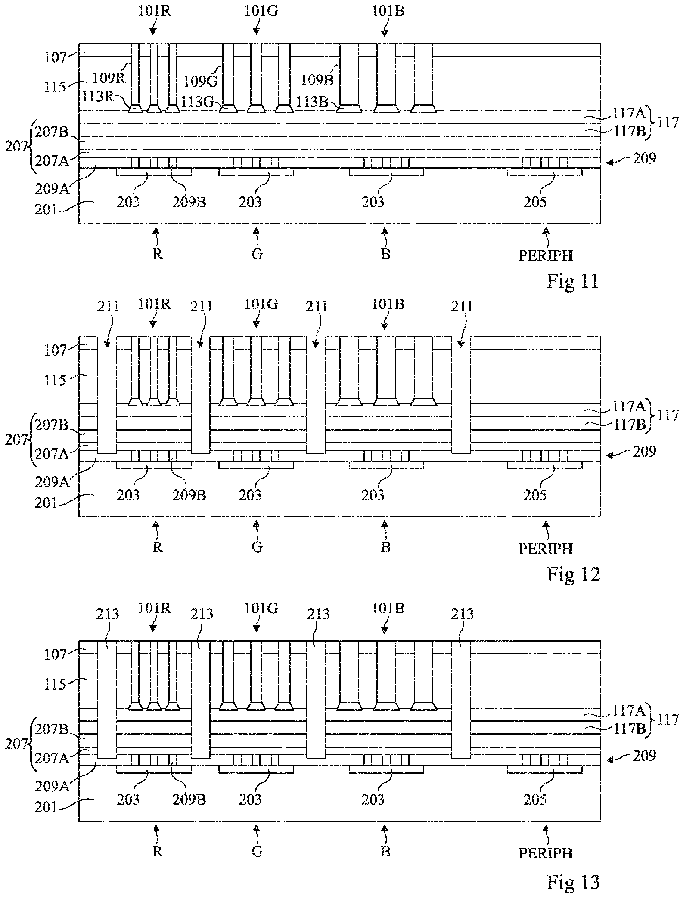

La figure 11 illustre la structure obtenue après une étape de retrait du substrat de support 103 et de la couche de nucléation 105 du circuit optoélectronique. Lors de cette étape, la face supérieure de la couche diélectrique 107 et la face supérieure des fils semiconducteurs 109R, 109G, 109B est exposée. Le substrat 103 peut être retiré par meulage et/ou gravure humide et/ou gravure sèche. La couche de nucléation 105 peut être retirée par gravure humide, gravure sèche, ou par CMP. La couche isolante 107 peut servir de couche d'arrêt de gravure lors de cette étape.

La figure 12 illustre la structure obtenue après une étape de formation de tranchées verticales 211 dans la structure de la figure 11, depuis la face supérieure de la structure, par exemple par photolithographie et gravure. Les tranchées 211 traversent entièrement les couches diélectriques 107 et 115 et délimitent latéralement les cellules d'émission 101R, 101G, 101B des différents pixels de l'écran. Chaque cellule d'émission 101R, 101G, 101B est entièrement entourée latéralement par des tranchées 211, et les cellules d'émission 101R, 101G, 101B adjacentes sont séparées par des tranchées 211. Les tranchées 211 traversent en outre entièrement les couches métalliques 117 et 207, de façon à isoler électriquement les unes des autres les cellules d'émission 101R, 101G, 101B des différents pixels de l'écran. Dans cet exemple, les tranchées 211 sont situées, en projection verticale, en regard des régions isolantes séparant latéralement les plots de connexion 203, 205 du circuit de contrôle. Dans l'exemple représenté, les tranchées 211 s'interrompent dans ou sur la face supérieure de la couche isolante 209A de la structure d'interconnexion 209. Dans le cas où la structure d'interconnexion 209 n'est pas présente, les tranchées 211 peuvent s'interrompre dans ou sur la face supérieure des régions isolantes séparant latéralement les plots métalliques de connexion 203, 205 du circuit de contrôle.

A l'issue de l'étape de formation des tranchées 211, dans chaque cellule d'émission 101R, 101G, 101B de l'écran, chaque LED élémentaire de la cellule a sa portion semiconductrice inférieure, correspondant par exemple à sa région d'anode, connectée électriquement au plot métallique de connexion 203 sous-jacent. Les portions semiconductrices inférieures des LED élémentaires de cellules d'émission distinctes sont en revanche isolées électriquement par les tranchées 211. Ceci permet un contrôle individuel des cellules d'émission 101R, 101G, 101B par le circuit de contrôle.

La figure 13 illustre la structure obtenue à l'issue d'une étape ultérieure de remplissage des tranchées 211 par un matériau isolant, par exemple de l'oxyde de silicium, de façon à former des murs isolants 213 entre les cellules d'émission 101R, 101G, 101B des différents pixels de l'écran. Le remplissage des tranchées peut comprendre le dépôt d'une couche d'un matériau isolant sur toute la surface supérieure de la structure de la figure 12, sur une épaisseur suffisamment importante pour combler entièrement les tranchées 211, suivie d'une étape d'amincissement et de planarisation de la couche isolante, par exemple par CMP, de façon à définir une surface supérieure sensiblement plane et à exposer les faces supérieures des fils semiconducteurs 109R, 109G, 109B.

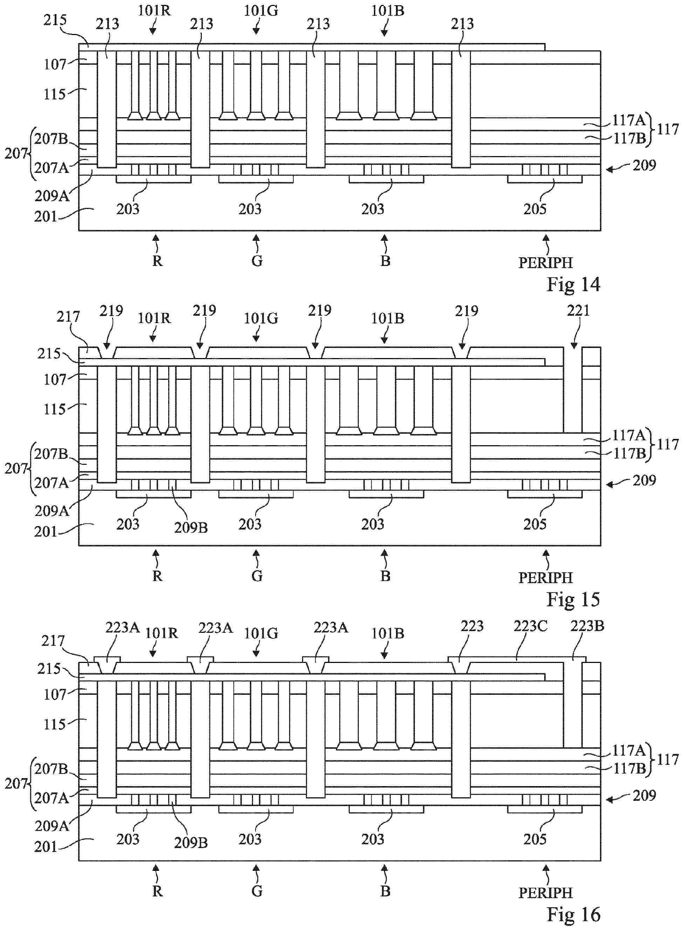

La figure 14 illustre la structure obtenue après une étape de dépôt d'une couche conductrice 215 sur la face supérieure de la structure de la figure 13. La couche 215 est au moins partiellement transparente aux rayonnements électromagnétiques émis par les LED élémentaires des cellules d'émission 101R, 101G, 101B. A l'issue de cette étape, chaque LED élémentaire a son fil semiconducteur 109R, 109G, 109B, correspondant par exemple à la région de cathode de la LED, connecté électriquement, par sa face supérieure, à la face inférieure de la couche conductrice 215. La couche conductrice 215 forme ainsi une électrode commune à toutes les cellules élémentaires d'émission 101R, 101G, 101B de l'écran. Le matériau formant la couche conductrice 215 peut être un matériau transparent et conducteur tel que du graphène ou un oxyde transparent et conducteur (ou TCO, de l'anglais Transparent Conducting Oxide), par exemple de l'oxyde d'indium-étain (ou ITO, de l'anglais Indium Tin Oxide), de l'oxyde de zinc dopé ou non à l'aluminium, ou au gallium ou au bore. A titre d'exemple, la couche conductrice 215 a une épaisseur comprise entre 20 nm et 500 nm, de préférence entre 20 nm et 100 nm. La couche 215 s'étend de façon continue sur sensiblement toute la surface de l'écran. La couche 215 peut toutefois être retirée sur au moins une partie de la surface de la partie périphérique PERIPH de l'écran tel qu'illustré sur la figure 14.

La figure 15 illustre la structure obtenue après les étapes suivantes :
- déposer une couche isolante 217, par exemple en oxyde de silicium, sur toute la surface supérieure de la structure de la figure 14, c'est-à-dire sur la face supérieure de la couche conductrice 215 et, le cas échéant, sur la face supérieure de la couche diélectrique 107 dans la partie périphérique PERIPH de l'écran ;
- former dans la couche 217 des tranchées verticales 219 débouchant sur la face supérieure de la couche conductrice 215, les tranchées 219 étant localisées en vis-à-vis des murs d'isolation 213, et formant, en vue de dessus, un motif en forme de grille continue sensiblement superposé aux murs d'isolation latéraux 213 ; et
- former, dans la région périphérique PERIPH de l'écran, depuis la face supérieure de la couche 217, une ou plusieurs ouvertures verticales 221 débouchant sur la face supérieure de la couche métallique 117.

Les ouvertures 221 peuvent être formées dans une partie de l'écran dans laquelle la couche conductrice 215 a été retirée préalablement au dépôt de la couche 217. Dans ce cas, les ouvertures 221 traversent uniquement les couches isolantes 217, 107 et 115. A titre de variante, la couche conductrice 215 n'est pas retirée dans la partie périphérique préalablement au dépôt, auquel cas les ouvertures 221 traversent aussi la couche conductrice 215.

Les ouvertures 219 et 221 sont par exemple formées par photolithographie et gravure.

La figure 16 illustre la structure obtenue après des étapes de formation d'une métallisation 223 constituée :
- d'une grille métallique continue 223A s'étendant dans les ouvertures 219, en contact avec la face supérieure de la couche conductrice 215 au fond des ouvertures 219 ;
- d'un ou plusieurs vias métalliques 223B situés dans les ouvertures 221, en contact avec la face supérieure de la couche métallique 117 au fond des ouvertures 221 ; et
- d'une ou plusieurs pistes métalliques 223C s'étendant sur la face supérieure de la couche 217 dans la partie périphérique PERIPH de l'écran et connectant la grille métallique 223A aux vias métalliques 223B.

La formation de la métallisation 223 peut comprendre une étape de dépôt d'un empilement d'une ou plusieurs couches métalliques, par exemple un empilement du type Ti/TiN/AlCu, s'étendant de façon continue sur toutes la surface supérieure de la structure de la figure 15, suivie d'une étape de gravure localisée de cet empilement, notamment en vis-à-vis des cellules d'émission 101R, 101G, 101B de l'écran, pour ne conserver que la métallisation 223.

La métallisation 223 permet de connecter la couche conductrice transparente 215, formant une électrode commune à toutes les LED élémentaires de l'écran, à un ou plusieurs plots de connexion 205 du circuit de contrôle. Dans l'exemple représenté, la grille 223A permet avantageusement de répartir le courant de façon homogène sur toute la surface de la couche 215. A titre de variante, la grille 223A peut être omise, le contact entre la métallisation 223 et la couche conductrice transparente étant formé uniquement dans la région périphérique PERIPH de l'écran.

Après la formation de la métallisation 223, une couche de passivation supérieure, non représentée, en un matériau isolant, peut être déposée sur toute la face supérieure de l'écran.

Outre l'avantage de simplification du procédé de fabrication lié à l'utilisation d'un collage direct métal-métal lors de l'assemblage du circuit optoélectronique sur le circuit actif de contrôle, un avantage de l'écran réalisé par le procédé des figures 1 à 16 est que les murs d'isolation latéraux 213 peuvent permettre de séparer optiquement les cellules d'émission des différents pixels de l'écran. Le ou les matériaux des murs d'isolation latéraux 213 sont par exemple choisis pour présenter un contraste d'indice relativement élevé, par exemple supérieur à 0,5, avec les matériaux des couches isolantes 115 et/ou 107, de façon que les murs 213 soient réfléchissants pour les rayonnements électromagnétiques émis par les LED élémentaires de l'écran.

A titre d'exemple, les murs d'isolation peuvent comprendre un matériau à faible indice de réfraction, par exemple de l'air ou de l'oxyde de silicium poreux. A titre d'exemple, les murs d'isolation 213 comprennent chacun une mince couche (non détaillée sur les figures) d'un premier matériau diélectrique, par exemple de l'oxyde de titane (TiO₂) ou de l'alumine (Al₂O₃), revêtant les parois latérales et le fond de la tranchée 211, par exemple une couche de l'ordre de 5 à 50 nm d'épaisseur, assurant l'isolation électrique, et un coeur (ou paroi centrale) d'un deuxième matériau diélectrique à relativement faible indice de réfraction, par exemple de l'air ou de l'oxyde de silicium poreux, remplissant le reste de la tranchée 211.

Le matériau de la couche 115, dans laquelle sont encapsulées les LED élémentaires tridimensionnelles, peut quant à lui être un matériau à relativement fort indice de réfraction, par exemple de l'oxyde de titane (TiO₂) déposé par un procédé sol-gel, par exemple tel que décrit dans l'article intitulé "Multifunctional Metasurfaces Based on Direct Nanoimprint of Titania Sol-Gel Coatings" de Simona Checcucci et al. (Adv. Optical Mater. 2019, 1801406, 2019).

Une pente de gravure peut de plus être prévue lors de la formation des tranchées 211, de façon à favoriser la réflexion vers l'intérieur de chaque cellule d'émission, de la lumière émise par les LED élémentaires se propageant dans le matériau de la couche 115, en direction de cellules voisines. A titre d'exemple, les parois latérales des tranchées 211 peuvent être sensiblement planes, et inclinées par rapport à la verticale de façon que la largeur des tranchées 211 diminue en allant du fond (ou base) vers l'ouverture (ou sommet) des tranchées 211 (dans l'orientation de la figure 12). A titre d'exemple, l'angle d'inclinaison des parois latérales des tranchées 211 (et donc des murs 213) est choisi en fonction des indices de réfraction respectifs de la couche 115 et du matériau de remplissage des murs 213, de façon qu'un rayon émis par une LED élémentaire tridimensionnelle, se propageant dans le matériau de la couche 115 à l'intérieur d'une cellule d'émission, selon une direction orthogonale au plan moyen du mur d'isolation 213 séparant la cellule d'une cellule voisine, soit réfléchi par réflexion totale sur l'interface entre la couche 115 et le matériau de remplissage du mur 213. A titre d'exemple, dans le cas où la couche 115 est en oxyde de silicium (indice optique de l'ordre de 1,46) et où le mur 213 comporte un coeur d'air (indice optique égal à 1), l'angle d'inclinaison des flancs des murs 213 peut être de l'ordre de 40 degrés. Dans le cas où la couche 115 est en oxyde de titane formé par un procédé sol-gel (indice optique de l'ordre de 2,3) et où le mur 213 comporte un coeur d'air (indice optique égal à 1), l'angle d'inclinaison des flancs des murs 213 peut être de l'ordre de 25 degrés.

La surface supérieure (ou face de sortie) de la couche 115 peut quant à elle présenter des rugosités de surface (non visibles sur les figures) formant un dépoli permettant d'éviter un phénomène de réflexion totale de la lumière provenant de l'intérieur de la couche 115, et ainsi favoriser l'extraction de la lumière émise par les LED tridimensionnelles.

A titre de variante, les parois latérales et le fond des tranchées 211 peuvent être revêtues d'une alternance de premières couches d'un premier matériau diélectrique transparent ayant un premier indice de réfraction et de deuxièmes couches d'un deuxième matériau diélectrique transparent ayant un deuxième indice de réfraction, ladite alternance de couches formant un réflecteur sur les flancs des tranchées. Le deuxième matériau présente de préférence un contraste d'indice relativement élevé, par exemple supérieur à 0,5, avec le premier matériau. Les premières et deuxièmes couches peuvent être relativement minces, par exemple d'épaisseurs comprises entre 10 et 100 nm. Le nombre d'alternances de couches est par exemple compris entre 1 et 5. A titre d'exemple, les premières couches sont en oxyde de titane, par exemple d'épaisseur de l'ordre de 50 nm, et les deuxièmes couches sont en oxyde de silicium, par exemple d'épaisseur de l'ordre de 84 nm. A titre de variante, les premières couches sont en alumine, par exemple d'épaisseur de l'ordre de 70 nm, et les deuxièmes couches sont en oxyde de silicium, par exemple d'épaisseur de l'ordre de 84 nm. Le reste de la tranchée 211 peut être rempli d'air ou d'oxyde de silicium poreux.

Dans une autre variante, constituant, elle, un mode de réalisation selon la présente invention telle que revendiquée, chaque mur d'isolation vertical 213 peut comprendre une couche isolante (non détaillée sur la figure), par exemple en oxyde de titane ou en alumine, revêtant les parois latérales et le fond de la tranchée 211, et une paroi centrale métallique réfléchissante (non détaillée sur la figure), par exemple en aluminium ou en tungstène, remplissant le reste de la tranchée.

Pour améliorer encore la séparation optique, une combinaison d'un miroir diélectrique multicouches et d'un miroir métallique peut être prévue. A titre d'exemple, les parois latérales et le fond des tranchées 211 peuvent être revêtues d'une alternance de premières et deuxièmes couches diélectriques d'indices différents, tel que décrit ci-dessus, le reste de la tranchée étant rempli par une paroi centrale métallique réfléchissante. Le nombre d'alternances de couches diélectriques est par exemple compris entre 1 et 3. A titre d'exemple, les premières couches sont en oxyde de titane, par exemple d'épaisseur de l'ordre de 44 nm, et les deuxièmes couches sont en oxyde de silicium, par exemple d'épaisseur de l'ordre de 74 nm. A titre de variante, les premières couches sont en alumine, par exemple d'épaisseur de l'ordre de 62 nm, et les deuxièmes couches sont en oxyde de silicium, par exemple d'épaisseur de l'ordre de 75 nm. La paroi métallique centrale peut être en aluminium ou en tungstène, par exemple d'épaisseur supérieure à 50 nm.

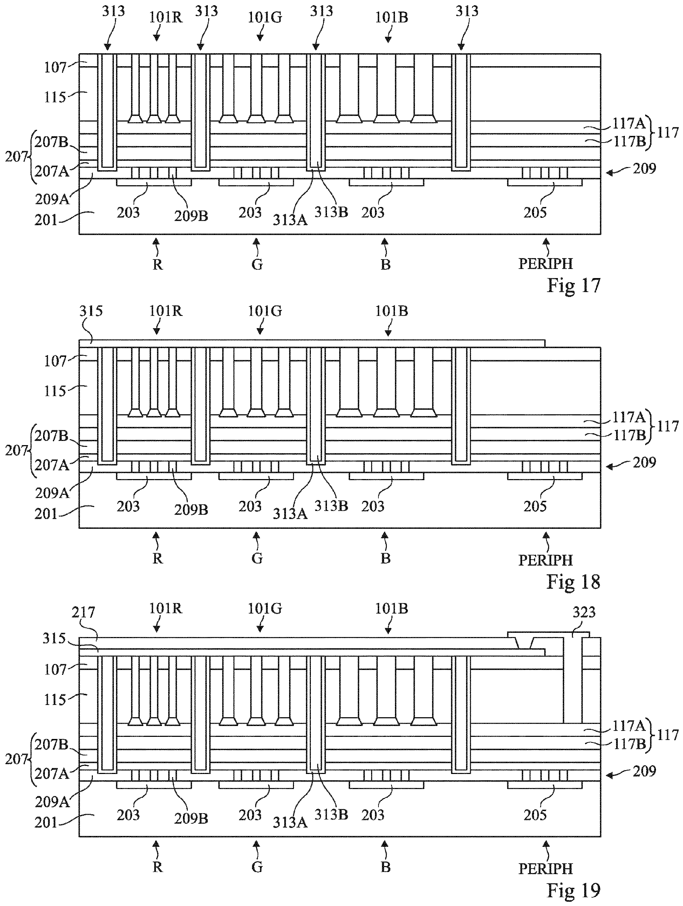

Les figures 17 à 19 sont des vues en coupe schématiques et partielles des structures obtenues à des étapes d'une variante constituant un mode de réalisation selon la présente invention telle que revendiquée, du procédé de fabrication d'un écran d'affichage émissif à LED décrit en relation avec les figures 1 à 16. Cette variante comprend des étapes initiales identiques à ce qui a été décrit précédemment en relation avec les figures 1 à 12.

La figure 17 illustre la structure obtenue après des étapes de formation de murs conducteurs isolés 313 dans les tranchées 211 de la structure de la figure 12. La formation des murs conducteurs isolés peut comprendre les étapes successives suivantes :
- déposer, par une méthode de dépôt conforme, une couche isolante 313A, par exemple en oxyde de silicium, sur toute la surface supérieure de la structure de la figure 12, c'est-à-dire sur les parois latérales et au fond des tranchées 211, ainsi que sur la face supérieure de la couche diélectrique 107 et des fils semiconducteurs 109R, 109G, 109B, la couche isolante 313A ne comblant pas entièrement les tranchées 211 ;
- déposer une couche métallique 313B sur toute la surface supérieure de la structure, sur une épaisseur suffisante pour combler entièrement les tranchées 211 ; et
- amincir et planariser la face supérieure de la structure, par exemple par CMP, de façon à obtenir une surface sensiblement plane et à ne conserver la couche isolante 313A et la couche métallique 313B que dans les tranchées 211.

La figure 18 illustre la structure obtenue après une étape de dépôt d'une couche conductrice transparente 315, identique ou similaire à la couche 215 de la figure 14, sur la face supérieure de la structure de la figure 17. Dans cette variante, la couche conductrice 315 est en contact, par sa face inférieure, non seulement avec les fils semiconducteurs 109R, 109G, 109B des LED élémentaires, mais également avec les parois conductrices 313B des murs d'isolation latéraux 313.

La figure 19 illustre la structure obtenue après les étapes successives suivantes :
- déposer une couche isolante 217, par exemple en oxyde de silicium, sur toute la surface supérieure de la structure de la figure 18 ; et
- former, dans et sur la couche 217 et dans les couches diélectriques 107 et 115, une métallisation 323 connectant la face supérieure de la couche conductrice 315 à la face supérieure d'une portion périphérique de la couche métallique 117.

Dans cette variante selon la présente invention telle que revendiquée, la métallisation 323 est entièrement située dans la partie périphérique PERIPH de l'écran. Les parois conductrices 313B des murs d'isolation latéraux 313 forment une structure conductrice continue en contact avec la face inférieure de la couche conductrice transparente 315, permettant d'assurer une répartition homogène du courant dans la couche 315.

La métallisation 323 peut être formée par un procédé identique ou similaire au procédé de formation de la métallisation 223 décrit en relation avec les figures 15 et 16.

Après la formation de la métallisation 323, une couche de passivation supérieure, non représentée, en un matériau isolant, peut être déposée sur toute la face supérieure de l'écran.

Un avantage de la variante selon la présente invention telle que revendiquée des figures 17 à 19 est qu'elle permet de limiter, voire de supprimer l'occultation de la couche conductrice transparente 315 par la métallisation de connexion de cette couche au circuit de contrôle. De plus, les parois métalliques 313B des murs d'isolation latéraux 313 permettent de renforcer la séparation optique entre les cellules d'émission des différents pixels et/ou d'améliorer l'évacuation de la chaleur générée dans les pixels lors du fonctionnement de l'écran.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits pour la présente invention ne se limitent pas aux exemples de dimensions et de matériaux mentionnés dans la présente description, mais s'inscrivent dans le cadre de l'étendue des revendications en annexe.

De plus, à titre de variante, à l'étape de la figure 4, les têtes 113R, 113G, 113B des LED élémentaires des différents types de pixels ne sont pas formées de façon simultanée sur les fils 109R, 109G, 109B, mais de façon séquentielle, avec trois étapes de croissance séparées au cours desquelles les fils au sommet desquels des têtes ne doivent pas être formées sont masqués. Les fils 109R, 109G, 109B peuvent alors tous avoir le même diamètre et le même pas interfil, les zones actives de têtes 113R, 113G, 113B étant formées avec des compositions différentes, par exemple avec des proportions d'indium différentes, pour obtenir des émissions à des longueurs d'onde différentes.

Par ailleurs, bien que l'on ait décrit ci-dessus uniquement des modes de réalisation dans lesquels les LED élémentaires tridimensionnelles des cellules d'émission des pixels sont des nanofils ou microfils semiconducteurs en configuration axiale, les modes de réalisation décrits ne se limitent pas à ce cas particulier. A titre de variante, les LED élémentaires tridimensionnelles des pixels peuvent être des nanostructures ou microstructures pyramidales en configuration radiale, de type coeur-coquille, par exemple telles que définies dans la demande de brevet WO 2019/002786 A1 susmentionnée, le contact électrique supérieur (via la couche conductrice 215 ou 315) étant alors réalisé sur la pointe des pyramides.

En outre, bien que l'on ait décrit ci-dessus uniquement des modes de réalisation dans lesquels les cellules d'émission des pixels comprennent chacune une ou plusieurs LED élémentaires tridimensionnelles, à titre de variante, l'écran peut combiner des pixels dont les cellules d'émission comportent chacune une ou plusieurs LED élémentaires tridimensionnelles, tel que décrit ci-dessus, et des pixels dont les cellules d'émission comportent chacune une unique LED planaire constituée d'un empilement de couches semiconductrices sensiblement planes s'étendant de façon continue sur toute la surface de la cellule.

Les revendications qui suivent définissent l'objet de la présente invention.

## Revendications

1. Procédé de fabrication d'un écran émissif à LED tridimensionnelles, comportant les étapes suivantes :
a) déposer une première couche métallique (207) sur une face d'un circuit de contrôle comportant une pluralité de plots métalliques de connexion (203, 205), la première couche métallique (207) s'étendant sur toute la surface du circuit de contrôle et étant connectée électriquement aux plots métalliques de connexion (203, 205) du circuit de contrôle ;
b) déposer une deuxième couche métallique (117) sur une face d'un circuit optoélectronique comportant des premières cellules d'émission (101R) adaptées à émettre un rayonnement électromagnétique à une première longueur d'onde et des deuxièmes cellules d'émission (101G) adaptées à émettre un rayonnement électromagnétique à une deuxième longueur d'onde différente de la première longueur d'onde, chaque première cellule d'émission (101R) comportant une ou plusieurs LED constituées chacune d'un élément semiconducteur tridimensionnel (109R, 113R), la deuxième couche métallique (117) s'étendant sur toute la surface du circuit optoélectronique et étant connectée électriquement à une première extrémité de chaque élément semiconducteur tridimensionnel du circuit optoélectronique ;
c) fixer le circuit optoélectronique au circuit de contrôle par collage direct de la deuxième couche métallique (117) sur la première couche métallique (207), en alignant le circuit optoélectronique par rapport au circuit de contrôle de façon que les différentes cellules d'émission (101R, 101G) du circuit optoélectronique soient disposées en vis-à-vis de plots métalliques de connexion (203) distincts du circuit de contrôle ; et
d) former, à partir de la face du circuit optoélectronique opposée au circuit de contrôle, des tranchées (211) délimitant latéralement chaque cellule d'émission (101R, 101G) du circuit optoélectronique, les tranchées traversant les deuxième (117) et première (207) couches métalliques de façon que les différentes cellules élémentaires d'émission (101R, 101G) soient connectées à des plots métalliques de connexion distincts du circuit de contrôle, le procédé comprenant en outre la formation de murs d'isolation latéraux ( 313) dans les tranchées (211),
les murs d'isolation latéraux (313) comprenant une couche isolante (313A) revêtant les parois latérales et le fond des tranchées (211), et une paroi centrale conductrice (313B).

2. Procédé selon la revendication 1, dans lequel chaque deuxième cellule d'émission (101G) comporte une ou plusieurs LED constituées chacune d'un élément semiconducteur tridimensionnel (109G, 113G).

3. Procédé selon la revendication 1 ou 2, dans lequel la deuxième couche métallique (117) comprend au moins une couche (117A) réfléchissante pour les rayonnements électromagnétiques émis par les premières (101R) et deuxième (101G) cellules d'émission.

4. Procédé selon la revendication 3, dans lequel ladite couche réfléchissante (117A) comprend de l'argent ou de l'aluminium.

5. Procédé selon l'une quelconque des revendications 1 à 4, dans lequel la première couche métallique (207) comprend une couche métallique de collage (207B) en contact avec une couche métallique de collage (117B) de la deuxième couche métallique (117), les couches métalliques de collage (207B, 117B) des première (207) et deuxième (117) couches métalliques étant en le même matériau.

6. Procédé selon la revendication 5, dans lequel les couches métalliques de collage (207B, 117B) des première (207) et deuxième (117) couches métalliques sont en Ti, Ni, Pt, Sn, Au, Ag, Al, Pd, W, Pb, Cu, AuSn, TiSn, NiSn ou en un alliage de tout ou partie de ces matériaux.

7. Procédé selon l'une quelconque des revendications 1 à 6, dans lequel la paroi centrale conductrice (313B) est en un métal réfléchissant, par exemple de l'aluminium ou du tungstène.

8. Procédé selon l'une quelconque des revendications 1 à 7, dans lequel :
- les tranchées (211) ont des parois latérales inclinées, et/ou ;
- un réflecteur constitué d'une alternance de couches diélectriques d'indices de réfraction distincts est formé sur les parois latérales des tranchées (211).

9. Procédé selon l'une quelconque des revendications 1 à 8, comportant en outre une étape de dépôt d'une couche conductrice transparente ( 315) sur la face du circuit optoélectronique opposée au circuit de contrôle, la couche conductrice transparente ( 315) étant en contact avec une deuxième extrémité de chaque élément semiconducteur tridimensionnel du circuit optoélectronique et formant une électrode commune à toutes les cellules d'émission (101R, 101G) du circuit optoélectronique.

10. Procédé selon la revendication 9, dans lequel la couche conductrice transparente ( 315) est en graphène ou en un oxyde transparent et conducteur.

11. Procédé selon la revendication 9 ou 10, comportant en outre la formation d'une métallisation ( 323) connectant électriquement la couche conductrice transparente ( 315) à un ou plusieurs plots de connexion (205) du circuit de contrôle.

12. Procédé selon l'une quelconque des revendications 9 à 11, dans lequel la couche conductrice transparente (315) est en contact, par sa face inférieure, avec la face supérieure des parois centrales conductrices (313B) des murs d'isolation latéraux (313).

13. Procédé selon l'une quelconque des revendications 1 à 12, dans lequel le circuit optoélectronique comporte en outre des troisièmes cellules d'émission (101B) adaptées à émettre un rayonnement électromagnétique à une troisième longueur d'onde différente des première et deuxième longueurs d'ondes.

14. Ecran émissif à LED tridimensionnelles, comportant :
- un circuit de contrôle dont une face comporte une pluralité de plots métalliques de connexion (203, 205), une première couche métallique (207) s'étendant sur ladite face du circuit de contrôle et étant connectée électriquement aux plots métalliques de connexion (203, 205) du circuit de contrôle ; et
- un circuit optoélectronique comportant des premières cellules d'émission (101R) adaptées à émettre un rayonnement électromagnétique à une première longueur d'onde et des deuxièmes cellules d'émission (101G) adaptées à émettre un rayonnement électromagnétique à une deuxième longueur d'onde différente de la première longueur d'onde, chaque première cellule d'émission (101R) comportant une ou plusieurs LED constituées chacune d'un élément semiconducteur tridimensionnel (109R, 113R), une deuxième couche métallique (117) s'étendant sur une face du circuit optoélectronique et étant connectée électriquement à une première extrémité de chaque élément semiconducteur tridimensionnel du circuit optoélectronique,
dans lequel le circuit optoélectronique est fixé au circuit de contrôle par collage direct de la deuxième couche métallique (117) sur la première couche métallique (207), de façon que les différentes cellules d'émission (101R, 101G) du circuit optoélectronique soient disposées en vis-à-vis de plots métalliques de connexion (203) distincts du circuit de contrôle, et dans lequel l'écran comprend une pluralité de tranchées (211) formées à partir de la face du circuit optoélectronique opposée au circuit de contrôle, les tranchées (211) délimitant latéralement chaque cellule d'émission (101R, 101G) du circuit optoélectronique, les tranchées traversant les deuxième (117) et première (207) couches métalliques de façon que les différentes cellules élémentaires d'émission (101R, 101G) soient connectées à des plots métalliques de connexion distincts du circuit de contrôle,
dans lequel les tranchées (211) contiennent des murs d'isolation latéraux ( 313) comprenant une couche isolante (313A) revêtant les parois latérales ;
**caractérisé en ce que**:
la couche isolante (313A) revêt également le fond des tranchées (211), et **en ce que** les murs d'isolation latéraux (313) comprennent en outre une paroi centrale conductrice (313B).

## Patentansprüche

1. Ein Verfahren zum Herstellen eines Emissionsbildschirms, der dreidimensionale LEDs aufweist, wobei das Verfahre folgende Schritte aufweist:
a) Abscheiden einer ersten Metallschicht (207) auf einer Oberfläche einer Steuerschaltung, die eine Vielzahl von Metallverbindungspads (203, 205) aufweist, wobei sich die erste Metallschicht (207) über die gesamte Oberfläche der Steuerschaltung erstreckt und elektrisch mit den Metallverbindungspads (203, 205) der Steuerschaltung verbunden ist;
b) Abscheiden einer zweiten Metallschicht (117) auf einer Oberfläche einer optoelektronischen Schaltung, die erste Emissionszellen (101R) aufweist, die in der Lage sind, eine elektromagnetische Strahlung bei einer ersten Wellenlänge zu emittieren, und zweite Emissionszellen (101G), die in der Lage sind, eine elektromagnetische Strahlung bei einer zweiten Wellenlänge zu emittieren, die sich von der ersten Wellenlänge unterscheidet, wobei jede erste Emissionszelle (101R) eine von einer Vielzahl von LEDs aufweist, die jeweils aus einem dreidimensionalen Halbleiterelement (109R, 113R) ausgebildet sind, wobei sich die zweite Metallschicht (117) über eine Oberfläche der optoelektronischen Schaltung erstreckt und elektrisch mit einem ersten Ende jedes dreidimensionalen Halbleiterelements der optoelektronischen Schaltung verbunden ist;
c) Bonden der optoelektronischen Schaltung an die Steuerschaltung durch direktes Bonden der zweiten Metallschicht (117) an die erste Metallschicht (207), und zwar durch Ausrichten der optoelektronischen Schaltung in Bezug auf die Steuerschaltung, so dass die verschiedenen Emissionszellen (101R, 101G) der optoelektronischen Schaltung gegenüber verschiedenen Metallverbindungspads (203) der Steuerschaltung angeordnet sind; und
d) Ausbilden, von der Oberfläche der optoelektronischen Schaltung gegenüber der Steuerschaltung, von Gräben (211), die jede Emissionszelle (101R, 101G) der optoelektronischen Schaltung seitlich begrenzen, wobei die Gräben die zweite (117) und die erste (207) Metallschicht durchqueren, so dass die verschiedenen elementaren Emissionszellen (101R, 101G) mit verschiedenen Metallverbindungspads der Steuerschaltung verbunden sind,
wobei das Verfahren ferner Ausbilden von isolierenden Seitenwänden (313) in den Gräben (211) aufweist, wobei die isolierenden Seitenwände (313) eine isolierende Schicht (313A) aufweisen, die die Seitenwände und den Boden der Gräben (211) bedeckt, und eine leitende Mittelwand (313B).

2. Das Verfahren nach Anspruch 1, wobei jede zweite Emissionszelle (101G) eine oder eine Vielzahl von LEDs aufweist, die jeweils aus einem dreidimensionalen Halbleiterelement (109G, 113G) ausgebildet sind.

3. Das Verfahren nach Anspruch 1 oder 2, wobei die zweite Metallschicht (117) wenigstens eine Schicht (117A) aufweist, die elektromagnetische Strahlung reflektiert, die von den ersten (101R) und zweiten (101G) Emissionszellen emittiert wird.

4. Das Verfahren nach Anspruch 3, wobei die reflektierende Schicht (117A) Silber oder Aluminium aufweist.

5. Das Verfahren nach einem der Ansprüche 1 bis 4, wobei die erste Metallschicht (207) eine Metallbondschicht (207B) aufweist, die mit einer Metallbondschicht (117B) der zweiten Metallschicht (117) in Kontakt steht, wobei die Metallbondschichten (207B, 117B) der ersten (207) und der zweiten (117) Metallschicht aus demselben Material hergestellt sind.

6. Das Verfahren nach Anspruch 5, wobei die Metallbondschichten (207B, 117B) der ersten (207) und zweiten (117) Metallschicht aus Ti, Ni, Pt, Sn, Au, Ag, Al, Pd, W, Pb, Cu, AuSn, TiSn, NiSn oder aus einer Legierung aller oder eines Teils dieser Materialien hergestellt sind.

7. Das Verfahren nach einem der Ansprüche 1 bis 6, wobei die zentrale leitende Wand (313B) aus einem reflektierenden Material, z.B. Aluminium oder Wolfram, hergestellt ist.

8. Das Verfahren nach einem der Ansprüche 1 bis 7, wobei:
- die Gräben (211) schräge Seitenwände aufweisen, und/oder;
- ein Reflektor, der aus einem Wechsel von dielektrischen Schichten mit unterschiedlichen Brechungsindizes ausgebildet ist, an den Seitenwänden der Gräben (211) ausgebildet wird.

9. Das Verfahren nach einem der Ansprüche 1 bis 8, ferner aufweisend einen Schritt der Abscheidung einer transparenten leitenden Schicht (315) auf der Oberfläche der optoelektronischen Schaltung gegenüber der Steuerschaltung, wobei die transparente leitende Schicht (315) in Kontakt mit einem zweiten Ende jedes dreidimensionalen Halbleiterelements der optoelektronischen Schaltung steht und eine gemeinsame Elektrode für alle Emissionszellen (101R, 101G) der optoelektronischen Schaltung bildet.

10. Das Verfahren nach Anspruch 9, wobei die transparente leitfähige Schicht (315) aus Graphen oder aus einem transparenten leitfähigen Oxid hergestellt ist.

11. Das Verfahren nach Anspruch 9 oder 10, ferner aufweisend Ausbilden einer Metallisierung (323), die die transparente leitende Schicht (315) mit einem oder einer Mehrzahl von Anschlusspads (205) der Steuerschaltung elektrisch verbindet.

12. Das Verfahren nach einem der Ansprüche 9 bis 11, wobei die transparente leitfähige Schicht (315) mit ihrer unteren Fläche in Kontakt mit der oberen Fläche der zentralen leitenden Wände (313B) der seitlichen isolierenden Wände (313) ist.

13. Das Verfahren nach einem der Ansprüche 1 bis 12, wobei die optoelektronische Schaltung ferner dritte Emissionszellen (101B) aufweist, die in der Lage sind, eine elektromagnetische Strahlung mit einer dritten Wellenlänge zu emittieren, die sich von den ersten und zweiten Wellenlängen unterscheidet.

14. Ein Emissionsbildschirm, der dreidimensionale LEDs aufweist, wobei der Bildschirm Folgendes aufweist:
- eine Steuerschaltung mit einer Oberfläche, die eine Vielzahl von Metallverbindungspads (203, 205) aufweist, wobei sich eine erste Metallschicht (207) über die Oberfläche der Steuerschaltung erstreckt und elektrisch mit den Metallverbindungspads (203, 205) der Steuerschaltung verbunden ist; und
- eine optoelektronische Schaltung aufweisend erste Emissionszellen (101R), die in der Lage sind, eine elektromagnetische Strahlung bei einer ersten Wellenlänge zu emittieren, und zweite Emissionszellen (101G), die in der Lage sind, eine elektromagnetische Strahlung bei einer zweiten Wellenlänge zu emittieren, die sich von der ersten Wellenlänge unterscheidet, wobei jede erste Emissionszelle (101R) eine aus einer Vielzahl von LEDs aufweist, die jeweils aus einem dreidimensionalen Halbleiterelement (109R, 113R) ausgebildet sind, wobei sich eine zweite Metallschicht (117) über eine Oberfläche der optoelektronischen Schaltung erstreckt und mit einem ersten Ende jedes dreidimensionalen Halbleiterelements der optoelektronischen Schaltung elektrisch verbunden ist,
wobei die optoelektronische Schaltung mit der Steuerschaltung durch direktes Bonden der zweiten Metallschicht (117) mit der ersten Metallschicht (207) gebondet ist, so dass die verschiedenen Emissionszellen (101R, 101G) der optoelektronischen Schaltung gegenüber verschiedenen Metallverbindungspads (203) der Steuerschaltung angeordnet sind, und wobei der Schirm eine Vielzahl von Gräben (211) aufweist, die von der Oberfläche der optoelektronischen Schaltung gegenüber der Steuerschaltung ausgebildet sind, wobei die Gräben (211)jede Emissionszelle (101R, 101G) der optoelektronischen Schaltung seitlich begrenzen, wobei die Gräben die zweite (117) und die erste (207) Metallschicht durchqueren, so dass die verschiedenen elementaren Emissionszellen (101R, 101G) mit verschiedenen Metallverbindungspads der Steuerschaltung verbunden sind,wobei die Gräben (211) isolierende Seitenwände (313) aufweisen, die eine Isolierschicht (313A) aufweisen, die die Seitenwände und den Boden der Gräben (211) bedeckt, und eine zentrale leitende Wand (313B).

## Claims

1. A method of manufacturing an emissive screen comprising three-dimensional LEDs, comprising the steps of:
a) depositing a first metal layer (207) on a surface of a control circuit comprising a plurality of metal connection pads (203, 205), the first metal layer (207) extending all over the surface of the control circuit and being electrically connected to the metal connection pads (203, 205) of the control circuit;
b) depositing a second metal layer (117) on a surface of an optoelectronic circuit comprising first emission cells (101R) capable of emitting an electromagnetic radiation at a first wavelength and second emission cells (101G) capable of emitting an electromagnetic radiation at a second wavelength different from the first wavelength, each first emission cell (101R) comprising one of a plurality of LEDs, each formed of a three-dimensional semiconductor element (109R, 113R), the second metal layer (117) extending over a surface of the optoelectronic circuit and being electrically connected to a first end of each three-dimensional semiconductor element of the optoelectronic circuit;
c) bonding the optoelectronic circuit to the control circuit by direct bonding of the second metal layer (117) to the first metal layer (207), by aligning the optoelectronic circuit with respect to the control circuit so that the different emission cells (101R, 101G) of the optoelectronic circuit are arranged opposite different metal connection pads (203) of the control circuit; and
d) forming, from the surface of the optoelectronic circuit opposite to the control circuit, trenches (211) laterally delimiting each emission cell (101R, 101G) of the optoelectronic circuit, the trenches crossing the second (117) and first (207) metal layers so that the different elementary emission cells (101R, 101G) are connected to different metal connection pads of the control circuit, the method further comprising the forming of lateral insulating walls (313) in the trenches (211), the lateral insulating walls (313) comprising an insulating layer (313A) coating the lateral walls and the bottom of the trenches (211), and a central conductive wall (313B).

2. The method according to claim 1, wherein each second emission cell (101G) comprises one or a plurality of LEDs, each formed of a three-dimensional semiconductor element (109G, 113G).

3. The method according to claim 1 or 2, wherein the second metal layer (117) comprises at least one layer (117A) reflective for the electromagnetic radiations emitted by the first (101R) and second (101G) emission cells.

4. The method according to claim 3, wherein said reflective layer (117A) comprises silver or aluminum.

5. The method according to any of claims 1 to 4, wherein the first metal layer (207) comprises a metal bonding layer (207B) in contact with a metal bonding layer (117B) of the second metal layer (117), the metal bonding layers (207B, 117B) of the first (207) and second (117) metal layers being made of the same material.

6. The method according to claim 5, wherein the metal bonding layers (207B, 117B) of the first (207) and second (117) metal layers are made of Ti, Ni, Pt, Sn, Au, Ag, Al, Pd, W, Pb, Cu, AuSn, TiSn, NiSn, or of an alloy of all or part of these materials.

7. The method according to any of claims 1 to 6, wherein the central conductive wall (313B) is made of a reflective material, for example, aluminum or tungsten.

8. The method according to any of claims 1 to 7, wherein:
- the trenches (211) have inclined lateral walls, and/or;
- a reflector formed of an alternation of dielectric layers of different refraction indexes is formed on the lateral walls of the trenches (211).

9. The method according to any of claims 1 to 8, further comprising a step of deposition of a transparent conductive layer (315) on the surface of the optoelectronic circuit opposite to the control circuit, the transparent conductive layer (315) being in contact with a second end of each three-dimensional semiconductor element of the optoelectronic circuit and forming an electrode common to all the emission cells (101R, 101G) of the optoelectronic circuit.

10. The method according to claim 9, wherein the transparent conductive layer (315) is made of graphene or of a transparent conductive oxide.

11. The method according to claim 9 or 10, further comprising the forming of a metallization (323) electrically connecting the transparent conductive layer (315) to one or a plurality of connection pads (205) of the control circuit.

12. The method according to any of claims 9 to 11, wherein the transparent conductive layer (315) is in contact, by its lower surface, with the upper surface of the central conductive walls (313B) of the lateral insulating walls (313).

13. The method according to any of claims 1 to 12, wherein the optoelectronic circuit further comprises third emission cells (101B) capable of emitting an electromagnetic radiation at a third wavelength different from the first and second wavelengths.

14. An emissive screen comprising three-dimensional LEDs, comprising:
- a control circuit having a surface comprising a plurality of metal connection pads (203, 205), a first metal layer (207) extending over said surface of the control circuit and being electrically connected to the metal connection pads (203, 205) of the control circuit; and
- an optoelectronic circuit comprising first emission cells (101R) capable of emitting an electromagnetic radiation at a first wavelength and second emission cells (101G) capable of emitting an electromagnetic radiation at a second wavelength different from the first wavelength, each first emission cell (101R) comprising one of a plurality of LEDs, each formed of a three-dimensional semiconductor element (109R, 113R), a second metal layer (117) extending over a surface of the optoelectronic circuit and being electrically connected to a first end of each three-dimensional semiconductor element of the optoelectronic circuit,
wherein the optoelectronic circuit is bonded to the control circuit by direct bonding of the second metal layer (117) to the first metal layer (207), so that the different emission cells (101R, 101G) of the optoelectronic circuit are arranged opposite different metal connection pads (203) of the control circuit, and wherein the screen comprises a plurality of trenches (211) formed from the surface of the optoelectronic circuit opposite to the control circuit, the trenches (211) laterally delimiting each emission cell (101R, 101G) of the optoelectronic circuit, the trenches crossing the second (117) and first (207) metal layers so that the different elementary emission cells (101R, 101G) are connected to different metal connection pads of the control circuit,
wherein the trenches (211) comprise lateral insulating walls (313) comprising an insulating layer (313A) coating the lateral walls and the bottom of the trenches (211), and a central conductive wall (313B).
